# EUROPEAN PATENT APPLICATION

(11) **EP 2 009 969 A2**
(43) Date of publication of application: **31.12.2008**
(21) Application number: 08252094.1
(22) Date of filing: 18.06.2008
(51) Int. Cl.: H05K 3/12

(54) **Systems and methods for curing a deposited layer on a substrate**

(30) Priority: 29.06.2007 US 771722
(71) Applicant: Weyerhaeuser Company, Federal Way, WA 98003 (US)
(72) Inventor: Hirahara, Edwin, Federal Way, WA 98023 (US); Lee, David L., Tacoma, WA 98407 (US)
(74) Representative: Bayliss, Geoffrey Cyril

(57) **Abstract**

Curing systems (20) are provided that include a planar support surface (22) for supporting a substrate (24) having at least one layer (26) deposited thereon, at least one curing device (28) for curing the at least one deposited layer, and a control system (32) for controlling the overall curing process. The curing device includes at least one laser (40), a lens module (42), and an optional modulator (44). During curing, the beam of light emitted from the laser may be directed onto the deposited layer by 1) controlling the position of an X-Y beam deflecting module to direct the focused beam of laser light onto a desired illumination area of the deposited layer; 2) controlling the position of the laser via an X-Y table (50), or 3) controlling the position of the substrate via an X-Y table (54).

## Description

The present invention is directed to systems and methods for curing layers deposited on a substrate, including printed layers of a printed electronics.

Electrically conducting and semiconducting polymers have become available in recent years. The use of conventional insulating polymers with conducting and semiconducting polymers enable the construction of micro-electronic components or complete or partially complete devices on a number of substrates. Some examples of micro-electric components that may be produced include capacitors, resistors, diodes, and transistors, while examples of complete devices may include RFID tags, sensors, flexible displays, etc.

Several methods of fabricating electronics with these polymers currently exist, including a method of printing polymers or the like layer by layer onto a substrate in a purely additive process. Electronics fabricated in a manner such as this are known as printed electronics. As an example, a capacitor can be constructed by depositing a conducting layer, followed by depositing an insulating layer and then another conducting layer. To obtain higher capacitance, either this process can be repeated or different material or material thicknesses may be utilized. As another example, a transistor can be formed by depositing a conductor layer forming source and drain electrodes, a semiconductor layer, a dielectric layer, and another conductor layer forming a gate electrode.

Printed electronics forming complete functional devices (e.g., RFID tags) may be produced at a very low cost when low-cost conducting and semiconducting materials, such as organic polymers, are used, and are believe to be somewhat less expensive to fabricate than analogous integrated circuits. Such low-cost printed electronics are not expected to compete directly with silicon-based integrated circuits. Rather, printed electronics may be produced to offer, for example, lower performance (e.g., lower frequency, lower power, or shorter lifetime) at much lower cost as compared to silicon-based integrated circuits.

Printed electronics are typically made using a set of materials, including dielectrics, conductors, and semi-conductors, that are deposited in a wet printing process. These are usually printable solutions, suspensions, or emulsions containing polymers, polymer precursors, inorganic materials, and organic or inorganic additives. Typical wet printing methods that may be employed include letterpress printing, screen printing, and ink jet printing. Specifically, these printable materials are deposited in a desired sequence onto a substrate. Once the layers are deposited onto the substrate, the printed electronics is often cured using a large convection oven.

These convection ovens, however, are bulky, and because their heating elements must usually be powered continuously during the fabrication process, they consume considerable energy. In addition, they require long curing times, e.g., 1 to 5 minutes or more. Conventions ovens also do not allow for selective curing of the deposited layers, and sometimes cause reheating of previously deposited materials.

This summary is provided to introduce a selection of concepts in a simplified form that are further described below in the Detailed Description, This summary is not intended to identify key features of the claimed subject matter, nor is it intended to be used as an aid in determining the scope of the claimed subject matter.

In accordance with aspects of the present invention, a curing system is provide. The system comprises a support having a planar surface for supporting a substrate having a material deposited thereon, a curing device comprising a laser capable of emitting a beam of light onto at least a portion of the deposited layer of material, and a control system connected in electrical communication with the curing device.

In accordance with another aspect of the present invention, a method of curing at least one deposited layer in a process of fabricating a printed electronics comprising a plurality of layers deposited onto a substrate is provided. The curing method includes emitting a beam of light from a laser and illuminating a deposited layer with the emitted beam of light, and moving the beam of light onto selected portions of the deposited layer.

In accordance with another aspect of the present invention, a method of fabricating a printed electronics is provided. The method includes(a) supporting a substrate with a support having a planar surface, (b) depositing via a printing device one of more materials onto the substrate in selected patterns, thereby forming a plurality of printed layers, and (c) laser curing at least a portion of each printed layer.

The curing methods and systems according to embodiments of the present invention, when used for printed electronics fabrication, may provide many benefits and advantages, including but not limited to, simplifying printed electronics fabrication, increasing throughput, reducing equipment cost and size, lowering curing energy requirements, and possibly decreasing volatile organic compounds given off in the curing process. This latter factor may allow smaller hoods, fans, and related solvent handling hardware needed to process these vapors and improved safety for operating personnel.

The foregoing aspects and many of the attendant advantages of this invention will become more readily appreciated by reference to the following detailed description, when taken in conjunction with the accompanying drawings, wherein:
FIGURE 1 is a schematic illustration of one exemplary curing system formed in accordance with aspects of the present invention;
FIGURE 2 is a schematic illustration of another embodiment of a curing system formed in accordance with aspects of the present invention;
FIGURE 3 is a schematic illustration of another embodiment of a curing system formed in accordance with aspects of the present invention;
FIGURE 4 is a schematic block diagram of one exemplary embodiment of a printed electronics fabrication system employing an embodiment of the curing system.

Embodiments of the present invention will now be described with reference to the accompanying drawings where like numerals correspond to like elements. The following description provides examples of systems and methods for curing a layer that was deposited on a substrate with the use of a laser. The examples of the curing systems and methods described herein are suitable for use in the fabrication of printed electronics, such as components, elements, completed circuits, partially completed circuits, devices, and the like.

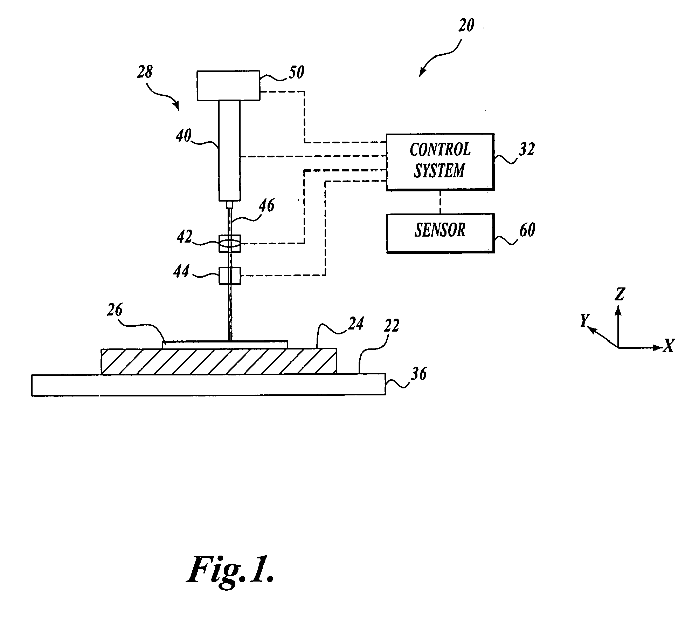

Referring now to FIGURE 1, there is shown a schematic diagram depicting one exemplary curing system, generally designated 20, which is formed in accordance with aspects of the present invention. Generally described, the system 20 includes a planar support surface 22 for supporting a substrate 24 having at least one layer 26 deposited thereon, at least one curing device 28 for curing the at least one deposited layer 26, and a control system 32 for controlling the overall curing process.

Referring now to FIGURE 1, the components of the system 20 will be described in more detail. In the embodiment of FIGURE 1, the support surface 22 is defined by the top of a stationary or movable bed or platen 36. In these embodiments, the substrate 24 may be placed on the bed or platen 34 manually or by automated material handling equipment (not shown) such as in-feeders, pick and place material handlers, etc. In other embodiments of the present invention, the support surface 22 may be a portion of a substrate advancement apparatus (not shown), such as a conveyor belt, conveyor tracks, or the like. The substrate 24 may be also in web form, and advanced with respect to the curing system 20 via substrate advancement apparatuses known in the art. In this embodiment, the support surface 22 may be defined by a bed or platen positioned under the curing device, which supports the web of substrate.

The curing device 28 is a device that cures one or more layers of material that has been deposited onto a substrate. In embodiments where the deposited material is printed for fabricating printed electronics, curing allows for the printed material to attain desirable electronic or electrical properties. In operation, the curing device 28 cures the layers of material by means of local heating, solvent evaporation, chemical reactions, etc. It will be appreciate that the deposited material may include a catalyst to initiate or accelerate the chemical reaction(s).

As best shown in FIGURE 1, the curing device 28 includes at least one laser 40, a lens module 42, and an optional modulator 44. The laser 40 is capable of generating a concentrated beam of laser light 46 that illuminates at least a portion of the deposited layer 26. Any laser type may be suitable for use in embodiments of the present invention. For example semiconductor lasers, gas lasers (helium-neon, argon, or carbon dioxide), excimer lasers, etc. may be used. It will be appreciated that the type of laser chosen may depend, in part, on the type of materials deposited so that the laser has sufficient power to achieve the desired level of curing. It may be desirable to employ lasers with specific wavelengths or lasers with variable wavelengths so as to induce chemical reaction curing or to stimulate an additive that catalyzes the curing of the deposited material. The laser 40 can be turned on and off by means of electrical signal from the control system 32.

The lens module 42 of the curing system 28 is disposed below the laser 40. The lens module 42 is capable of adjusting the focus of the light 46 emitted from the laser 40, which can be controlled with electrical signals from the control system 32. Focus adjustability provides the ability to dynamically maintain a desired laser beam illumination area on the deposited layer 26, for example, a printed electronics layer, on substrate 24. It may also be desirable in several embodiments where sufficient laser power is available, to defocus the beam of laser light using lens module 42 to create a larger illumination area. Thus a larger area could be cured at one time. This can make it possible to achieve a shorter overall curing time. By means of dynamic control of the illumination area, high-resolution could be achieved where desired by refocusing the lens module 42 to make a small illumination area when desired.

The curing device 28 may optionally include a modulator 44 positioned below the lens module 42. The beam of laser light 46 exiting the lens module 42 passes through the modulator 44, which is configured to vary the intensity of the beam of laser light passing therethrough. Such modulation can be done by one of several methods well known in the art. The amount of light passed by the modulator 44 can be controlled with electrical signals from the control system 32.

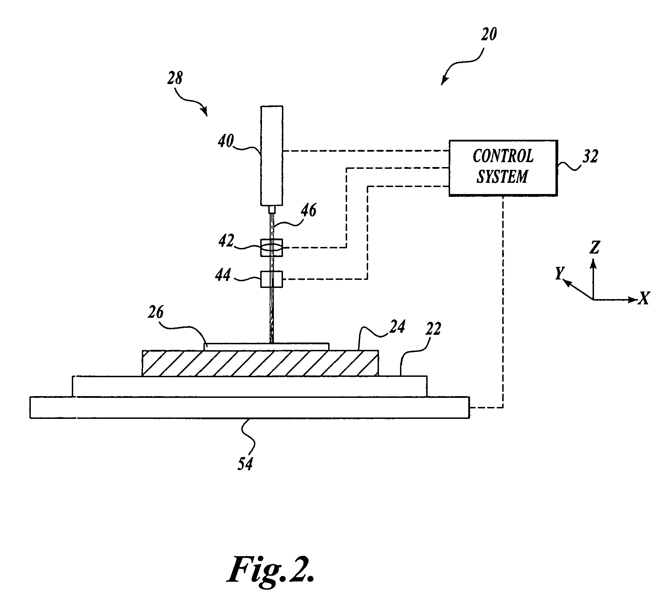

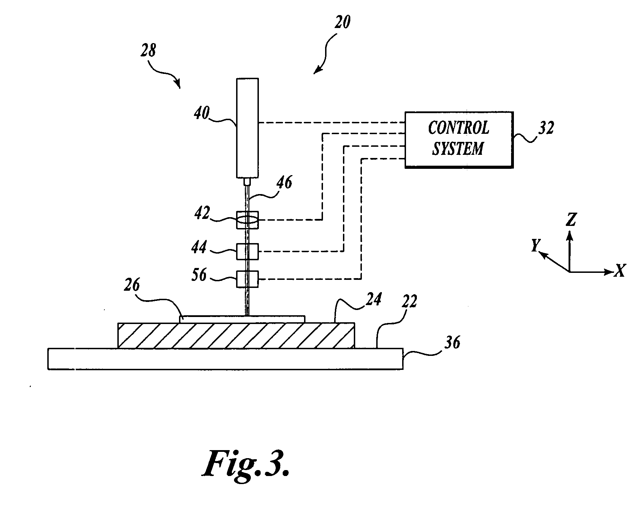

In the embodiment shown in FIGURE 1, the curing device 28 is mounted on a conventional X-Y table 50. By mounting the curing device 28 on the X-Y table 50, the movement of the laser 40, and thus the placement of the beam of laser light 46, can be advantageously controlled in an XY plane parallel to the planar support surface 22 in order to cure the layer of material at desired locations. While the curing device 28 is mounted for movement on an X-Y table 50 in the embodiments heretofore described, it should be appreciated that other configurations may also be utilized. For example, the bed or platen 36 that defines the support surface 22 can be mounted on an X-Y table 54, and moved with respect to the curing device 28, as best shown in the embodiment of **FIGURE** 2. Alternatively, as best shown in the embodiment of FIGURE 3, an X-Y beam deflecting module 56 may be utilized instead. In this embodiment, the laser 40, lens module 42, and optional modulator 44 are fixed in a stationary position. When the beam of laser light 46 exits the lens module 42 or the optional modulator 44, the X-Y beam deflecting module 56 controls the angle of the beam in both the X and Y directions so as to illuminate the deposited layer of material at a selected position.

In yet another embodiment, a hybrid system may be utilized for providing suitable operational performance. In this embodiment, the hybrid system could include a beam deflecting module that deflects the laser light in one direction, e.g., the X direction, and a movement table supporting the substrate for motion in another direction, e.g., the Y direction. Such as system would have high-speed motion in the X axis and high precision but possibly slower positioning along the Y axis. In a second example of such a hybrid system, both an X-Y beam deflecting module 56 and an X-Y motion table 50 and/or 54 could be used. This system provides both high speed and high precision positioning of the beam of laser light along both X and Y axes. The X-Y motion table 54 could move the support surface 22 and substrate 24 under a stationary laser 40, lens module 42, etc., or the X-Y motion table 50 could move the laser 40, lens module 42, etc. over the support surface 22.

As briefly discussed above, the system 20 further includes a control system 32, which controls at least the curing process. The control system 32 may comprise a computer or other processor appropriately programmed for controlling the curing process. In one embodiment, the control system 32 includes a computer with stored programs, data, etc., and various input/output circuitry to transmit the proper control signals to control the operation of the laser 40, the lens module 42, the optional modulator 44, the beam deflecting module 56, X-Y tables 50 and 54, a substrate advancement apparatus, material handling equipment, etc.

One suitable method for using the system 20 to cure a deposited layer of material will now be described with reference to FIGURES 1-2. As best shown in FIGURE 2, a substrate, such as substrate 24 having a deposited layer 26 thereon, is supported by the support surface 22 in a suitable position with respect to the curing device 28. The substrate 24 may be placed onto the support surface 22 manually or transferred thereto by one of any number of automated material handling systems. Once the substrate 24 is in a suitable position with respect to the curing device 28, the curing device 28 is suitably operated to cure the deposited layer of material. In one embodiment, the control system 32 sends appropriate control signals to turn on the laser 40, focus the lens module 42, modulate the intensity of the beam of laser light via the modulator 44 if desired, and direct the focused beam of laser light 46 onto a selected portion of the deposited layer of material. The focused beam of laser light 46 may be directed by one of the following methods: 1) controlling the position of the X-Y beam deflecting module 56 to direct the focused beam of laser light 46 onto a desired illumination area of the deposited layer of material; 2) controlling the position of the laser 40 via the X-Y table 50, or 3) controlling the position of the substrate 22 via the X-Y table 54. The beam of laser light 46 is then appropriately moved, for example, in a raster scan, to apply photons to specific portions of the deposited layer of material. This curing process continues until as much of the deposited layer has been cured as desired.

In some embodiments, it is desirable to uniformly cure the printed layers of material. To achieve uniform curing, the dose of photons from the beam of laser light 46 is controlled. This can be accomplished either by turning the laser 40 off and on as the beam is positioned over each desired portion of the deposited material, or by controlling the intensity (e.g., by using a modulator 44) and/or the speed of movement of the laser light as it moves along a path of the area being cured. In another embodiment of the present invention, suitable curing may be achievable using non-constant laser intensity at each position of the deposited layer of material. For example, improved curing may be attained by using a short high-intensity pulse of laser light followed by a longer lower intensity pulse, or visa-versa.

Embodiments of the present invention having the capability of controlling the dose of photons of the beam of laser light may also provide improved curing of the deposited layers when it is desired, for example, that certain areas of the deposited layer to have a larger dose than others. For example, edges of traces and areas over a region of high thermal conductivity may require a larger dose of photons to cure these portions of the deposited layers more completely. Controlling the photon dose to provide the minimum dose necessary at each position on the deposited layer also provides a shorter cure time for each layer compared with a uniform dose large enough to cure the most-difficult-to-cure region of the deposited material. An additional advantage may be realized with the capability of controlling the dose of photons in that such a system can accommodate individual curing characteristics and requirements for each material from the set of materials. This is particularly desirable when fabricating printed electronics.

In many cases it may be desirable to deposit a layer of material in an area greater than necessary and curing only a selected portion thereof. This may enable lower-cost, lower precision, and faster completion times. Curing only part of the deposited layer of material can be done by curing only a small area at a time with a focused beam of laser light and then moving the beam of laser light with respect to the substrate 24 in conjunction with turning the laser off and on or variable control of beam intensity so that all desired areas of the deposited material are cured.

While a single source of laser light has been shown and described, other embodiments of the present invention may advantageously use multiple lasers. Alternatively, instead of using two or more lasers, the beam of laser light of a single laser may be split into multiple beams if sufficient laser power is available. This can be done for example by a two-dimensional diffraction pattern. By these means, curing of more than one spot on the polymer could be done simultaneously.

In another embodiment of present invention invention, a light sensor or image sensor 60 may be included in the system 20. The light sensor or image sensor 60 is capable of viewing the deposited layer of material as it is being cured. The output of this sensor (or these sensors) is monitored by the control system 32 and used to control the curing process. Suitable sensors might be CCD or CMOS video sensors, or visible light or infrared photo-sensors. By this means_{;} improved curing performance, quality, and/or speed may be achieved. The image sensor could also be used to view the fiducial marks on the printed electronics to assist in registration of the laser beam position. In several embodiments, the sensor(s) could also detect and read identification and/or serial numbers on the printed electronics, and with this information the control system 32 can choose the desired curing pattern and algorithm for curing the current particular electronics type and deposited material from the data stored in its memory.

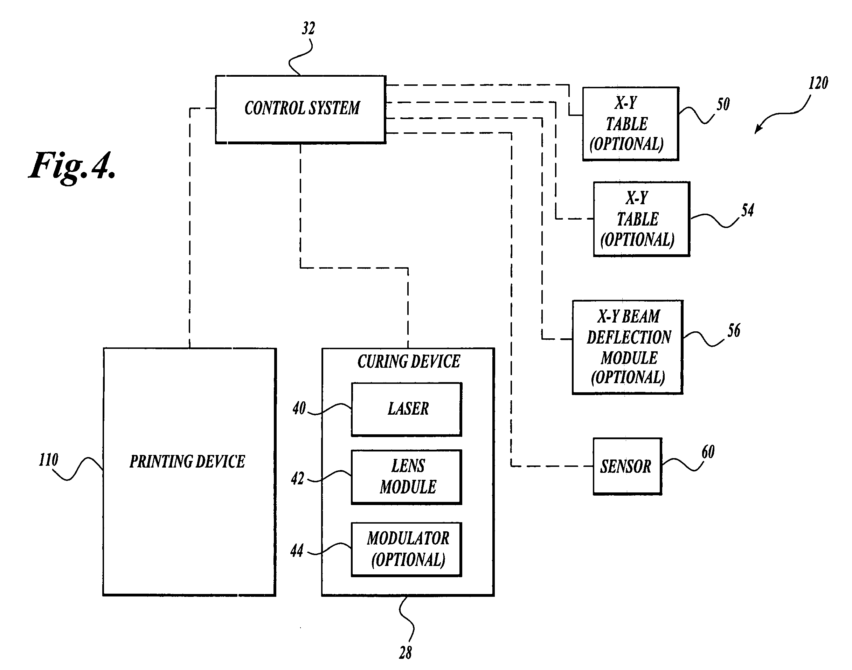

Embodiments of the curing systems and methods may be suitably used in a number of larger systems and methods. For example, as best shown in FIGURE 4, the curing system 20 may be part of a printed electronics fabrication system 120. The printed electronics fabrication system 120 includes at least one printing device 110 for depositing one or more layers of material in selected patterns onto the substrate 24 for forming a printed electronics, such s a capacitor, transistor, etc., and the curing system 20 for curing one or more layers of deposited material. In this embodiment, the control system 32 may also control the printing process or the system 120 may include a separate print control system (not shown). Additionally, the system 120 may include separate printing and curing stations such that the substrate is transferred and properly aligned between the printing and curing stations via any known material handling system, such as a conveyor assembly, a pick and place system using a robot arm, etc, or the substrate could be in web form and transferred in any manner known in the art. As such, the layers of the printed electronics are deposited and cured sequentially in an additive process.

Although embodiments of the present invention has been described with reference to examples illustrated in the attached drawings, it is noted that substitutions may be made and equivalents employed herein without departing from the scope of the present invention as recited in the claims. It is therefore intended that the scope of the invention be determined from the following claims and equivalents thereof.

## Claims

1. A curing system, comprising:
a support having a planar surface for supporting a substrate having a material deposited thereon;
a curing device comprising a laser capable of emitting a beam of light onto at least a portion of the deposited layer of material; and
a control system connected in electrical communication with the curing device.

2. A system as claimed in Claim 1, wherein the support and/or the curing device is movable in an XY plane.

3. A system as claimed in Claim 1 or Claim 2, further including an X-Y beam deflector connected in electrical communication with the control system, the X-Y beam deflector capable of deflecting the beam of light with respect to the support.

4. A system as claimed in any of Claims 1 to 3, further comprising a motion device associated with the support, the motion device capable of moving the support in the XY plane, wherein the relative motion between the beam of light and the support is accomplished by a combination of the X-Y beam deflector and motion of the support planar surface.

5. A system as claimed in any of Claims 1 to 4, wherein the curing device includes two or more lasers emitting beams of light substantially parallel and having approximately the same optical path.

6. A system as claimed in any of Claims 1 to 5, wherein two or more beams of light are formed from the beam of light emitted from the laser for producing two or more illuminating area on the deposited layer.

7. A system as claimed in any of Claims 1 to 6, wherein the beam of light emitted by the laser has a wavelength and intensity, the wavelength and intensity of the beam of light being chosen so that the beam of light induces a chemical reaction in the deposited material.

8. A system as claimed in any of Claims 1 to 7, wherein the deposited layer includes one or more chemical additives and wherein the beam of light emitted by the laser has a wavelength and intensity, the wavelength and intensity of the beam of light being chosen so that the beam of light induces chemical reactions with respect to the chemical additives.

9. A system as claimed in any of Claims 1 to 8, wherein the beam of light is applied in two or more pulses of controllable length and/or intensity to enhance curing speed and/or quality.

10. A system as claimed in any of Claims 1 to 9, further comprising at least one optical sensor for viewing the deposited layer during curing to accomplish one or more of the following: 1) identifying a circuit type; 2) identifying the layer material; and/or 3) providing feedback to the control system in order to improve curing performance and/or quality.

11. A system as claimed in any of Claims 1 to 10, wherein the curing device further includes a lens module that adjusts the focus of the beam of light emitted from the laser and/or a modulator that modulates the intensity of the beam of light emitted from the laser.

12. A system as claimed in any of Claims 1 to 11, wherein the deposited layer of material is a printed layer of a printed electronics.

13. In a process of fabricating a printed electronics comprising a plurality of layers deposited onto a substrate, a method of curing at least one deposited layer comprising the steps of:
emitting a beam of light from a laser and illuminating a deposited layer with the emitted beam of light; and
moving the beam of light onto selected portions of the deposited layer.

14. A method as claimed in Claim 13, wherein moving the beam of light includes one of the following steps: 1) moving the substrate with respect to the laser; 2) moving the laser with respect to the substrate; and 3) deflecting the beam of light.

15. A method as claimed in Claim 13 or Claim 14, further comprising the step of focusing and/or defocusing the beam of light emitted from the laser for illuminating the selected portions of the deposited layer.

16. A method as claimed in any of Claims 13 to 15, further comprising the step of modulating the intensity of the beam of light.

17. A method as claimed in any of Claims 13 to 16, wherein the selected portions of the deposited layer are subjected to different levels of curing.

18. A method of fabricating a printed electronics, comprising the steps of:
(a) supporting a substrate with a support having a planar surface;
(b) depositing via a printing device one of more materials onto the substrate in selected patterns, thereby forming a plurality of printed layers; and
(c) laser curing at least a portion of each printed layer.
